# EUROPEAN PATENT SPECIFICATION

(11) **EP 1 396 019 B1**
(45) Date of publication and mention of the grant of the patent: **08.07.2015**
(21) Application number: 02769196.3
(22) Date of filing: 06.05.2002
(51) Int. Cl.: H01L 21/336

(54) **THIN FILM TRANSISTOR SELF-ALIGNED TO A LIGHT-SHIELD LAYER**
AUF EINE LICHTABSCHIRMSCHICHT SELBST-AUSGERICHTETER DÜNNFILMTRANSISTOR
TRANSISTOR A COUCHE MINCE AUTO-ALIGNE SUR UNE COUCHE ECRAN

(30) Priority: 10.05.2001 JP 2001139552
(43) Date of publication of application: 10.03.2004
(73) Proprietor: TPO Hong Kong Holding Limited, Shatin, Hong Kong (CN)
(72) Inventor: YUKAWA, Teizo, NL-5656 AA Eindhoven (NL)
(74) Representative: Nederlandsch Octrooibureau
(86) International application number: PCT/IB2002/001581
(87) International publication number: WO 2002/091455

(56) References cited:
- WO-A-02/19412
- US-A- 4 778 773
- US-A- 5 091 337
- US-A- 5 371 025
- US-A- 5 747 828

## Description

### BACKGROUND OF THE INVENTION

### Field of the Invention

The present invention relates to a method of manufacturing a thin film transistor (TFT) and more particularly to an improved method of manufacturing thin film transistors suitable for use, for example, as elements for driving pixel electrodes of a liquid crystal display panel. The present invention further relates to a thin film transistor and a liquid crystal display panel manufactured using such manufacturing method.

### Description of Related Art

Thin film transistors are widely used in electronic devices such as liquid crystal display devices. In particular, in a liquid crystal display panel of the active-matrix type, TFTs each having a source electrode, a drain electrode, a gate electrode and a channel region are used as elements for supplying pixel information to the pixel electrodes. Active-matrix liquid crystal display panels of the transmission type includes some in which shield films are provide for such TFTs (their channel regions, in particular), respectively, in order to prevent a light from the back light system disposed behind the display panel from entering them.

In a liquid crystal display panel of the above type, for example, when a given TFT is controlled to be in a fully off-state a leak current may be generated between the drain and the source due to optically excited carriers if a light from the back light system enters the channel region of this TFT. As a result, the potential of the corresponding pixel electrode changes, which leads to degradation in quality of the displayed picture. The above-described shield films maintain such entry of light into the channel regions of the TFTs as little as possible to prevent the degradation in quality of the displayed picture.

A liquid crystal display panel provided with such shield films is known, for example, from US Patent Nos. 4,723,838 and 5,691,782.

The liquid crystal display panel disclosed in US Patent No. 4,723,838. comprises, on the rear side of the display panel, shield films in correspondence with TFTs each of which is provided for a respective one of pixel electrodes arranged in a matrix. Each of these shield films serves to prevent a light from the back light system from entering a channel (a semiconductor layer) of the corresponding TFT. Conventionally, such shield films are formed in the following manner.

A film of a light-shielding material such as a metal is uniformly formed on a transparent substrate. The light-shielding material film is then subjected to a patterning process to remove those portions other than the regions which correspond to TFTs to be formed, with the result that a number of shield films are formed. Usually, an insulating layer made of SiO2, silicon nitride or the like and a transparent conductive layer made, for example, of ITO are then sequentially formed on the substrate on which the shield films have been formed in the above-described manner. Source electrodes, drain electrodes and pixel electrodes integral with the drain electrodes, respectively, are formed from the above transparent conductive layer by means of a patterning process. Then, the substrate provided with these elements is formed sequentially with a channel forming layer made of amorphous silicon (a-Si) or the like and a gate insulating layer made of silicon nitride or the like. The last-mentioned two layers are removed except for those island-shaped regions, respectively, by patterning a photo-resist layer formed on the gate insulating layer by its exposure to a light from a light source arranged on the top side (or on the side of the photo-resist layer) and the subsequent development and by carrying out an etching with the thus patterned photo-resist layer used as a mask. Each of these island-shaped regions is then provided on its top with a gate electrode, whereby a TFT is formed. Alternatively, use can be made of organic materials for the insulating and semiconductor layers, such as known from WO-A 01/15223.

In the above-described conventional method of manufacturing TFTs, in addition to a photo mask for use in the process of forming the shield films another photomask for use in the process of forming the island-shaped regions is required. Usually, the above two masks are different ones and a positional error will occur in each positioning process of these masks, so that it is quite difficult to make the associated shield film and island-shaped region coincide in position and shape to each other as viewed in a direction perpendicular to the substrate. As a consequence, a light from the back light system may enter the island-shaped regions, i.e., the channel forming regions of the TFTs, whereby optically excited carriers are induced. These carriers cause leak currents between the drains and sources to increase, which may adversely affect the quality of the displayed picture. When the shield films are formed larger to prevent such entry of light, the numerical aperture of the panel may decrease, or a dark picture may result due to the excessive blocking of light from the back light system.

US-A-5 747 828 describes a method of manufacturing a thin film transistor comprising a substrate (20). According to US-A-5 747 828 the substrate is transparent and is provided with the mask for patterning the channel forming layer, the mask is being a shield layer to prevent light from entering the channel. More specifically, this document discloses a method of manufacturing a thin film transistor comprising a substrate; a source and a drain electrode that are mutually separated by a channel; and a gate electrode that is isolated from the channel through a gate insulating layer, wherein the gate electrode is formed on the island-shaped channel with the gate insulating layer being interposed therebetween, the channel being formed comprising the steps of applying a channel forming layer and photolithographical patterning of the channel forming layer with a mask, wherein the substrate is transparent and is provided with the mask for patterning the channel forming layer, the mask being a shield layer to prevent light from entering the channel.

### SUMMARY OF THE INVENTION

It is therefore an object of the present invention to provide a method of manufacturing a thin film transistor which can substantially eliminate, without degrading the display performance such as the numerical aperture, the possibility that a light enters a channel forming layer of the thin film transistor.

It is another object of the invention to provide a method of manufacturing a thin film transistor of the above type which requires a reduced number of photo masks and thus has simpler and less costly manufacturing steps as compared to the conventional method.

It is a further object of the invention to provide a thin film transistor which can substantially eliminate the possibility of light entering a channel forming layer thereof without degrading the display performance such as the numerical aperture.

It is a further object of the invention to provide a thin film transistor of the above type which can be manufactured at less cost.

It is a further object of the invention to provide a liquid crystal display panel which comprises thin film transistors of the above type and is less adversely affected by the back light system in terms of the picture quality.

To achieve the above objects, according to the present invention, there is provided a method of manufacturing a thin film transistor according to claim 1.

According to this method, when forming the island-shaped channel forming layer the exposure to light is performed from the side of the substrate (i.e., from the rear side) with the shield layer being used as a photomask, so that there is no need to provide another photomask which has been required in the conventional manufacturing method for the exposure from the front side, whereby the manufacturing steps are simplified. As a result of the shield layer being used as a photomask, the shield layer and the island-shaped channel forming layer agree in shape and position to each other substantially completely when viewed in a direction perpendicular to the substrate, that is to say both layers are self aligned. Thus, the occurrence of such phenomenon that optically excited carriers are induced by the light from the back light system entering the channel forming layer can be avoided in an efficient manner without sacrificing the numerical aperture and the like.

In a first embodiment of the method the source and drain electrodes are provided on the substrate, onto which the channel forming layer is applied. The gate electrode is then present on top. The channel is therewith in fact present between the shield layer and the gate electrode, that comprises a light-blocking conductive material, such as a metal or an organic conductive layer filled with black particles.

In a further embodiment the photolithographical patterning comprises the steps of:
- providing a photoresist layer on the gate insulating layer;
- patterning the photoresist layer based on exposing light from the side of said transparent substrate with said shield layer being used as a mask; and
- selectively etching a lamination of said gate insulating layer and said channel forming layer with the patterned photoresist layer being used as a mask, therewith forming the island-shaped channel.

Although the photoresist layer may be patterned directly, for example by the addition of photochemical radical initiators, it is preferred that the patterning occurs indirectly, via an intermediate photoresist layer. According to this embodiment, the photoresist layer is present on top of the gate insulating layer. This has the advantage that the channel - and in particular the interface between the channel and the gate insulating layer - is protected from contaminations.

After the preferably indirect patterning of the channel forming layer the channel may be further protected. In a first variant which is not covered by the claims a protective layer serving as a second gate insulating layer is provided. In a second variant according to the invention side faces of the channel that contains amorphous silicon is locally oxidized.

In a second embodiment which is not covered by the claims the method comprises the steps of:
- providing the gate electrode as the shield layer on the substrate or an undercoat layer provided thereon, the gate-electrode comprising a light-blocking conductive material,
- forming the gate insulating layer thereon,
- forming the source electrode and the drain electrode on the gate insulating layer,
- applying the channel forming layer on said gate insulating layer on which the source and drain electrodes have been formed.

According to this embodiment the gate electrode acts as the shield layer, and is present on the substrate. The resulting transistor is thus of the bottom gate type. Dependent on the application of the transistor and of the material of the channel, it may be that no further shield layer on top of the source and drain electrodes is necessary anymore. If it is necessary, it can be provided as a unpatterned layer or as a patterned layer. The layer can be patterned according to the same pattern as the layer comprising the gate electrode. This has the advantage that the number of masks can be reduced.

Also in this second embodiment, it is preferred that the channel forming layer is patterned indirectly. Therefore, an additional insulating layer is applied on top of the channel forming layer before the photolithographical patterning.

It is advantageous to provide a protective layer on top of the channel. Such a protective layer preferably delimits a pixel region, if the transistor is to be used in a liquid crystal display.

It is observed that many transistors can be provided in a single substrate in a single process as outlined in the claims. Further on, the source and the drain electrode are generally provided as patterns in a single layer, that will further contain a plurality of interconnect lines. The gate electrode is provided as a pattern in a layer as well and further contains a plurality of interconnect lines. The source or the drain electrode is connected to a pixel electrode, if used in a liquid crystalline display.

According to the present invention, there is further provided a liquid crystal display comprising a thin film transistor obtainable with the method according to any of the Claims 1-8, further comprising a pixel electrode connected to the source or drain electrode and a layer of liquid crystalline material. This display can be made cost-effectively. It has a good picture quality and good life time by virtue of the fact that no leakage curretn will be induced in the channel under the influence of the back light system.

These and other aspects of the invention will be further discussed and elucidated with reference to the drawings, in which:

### BRIEF DESCRITPTION OF THE DRAWINGS

Fig. 1 is a diagrammatic plan view of a part of a liquid crystal display panel having thin film transistors manufactured in accordance with a first embodiment.
Fig. 2 is an illustration showing the part of Fig. 1 in cross-section taken along the line II-II of Fig. 1 in various manufacturing steps of the first embodiment.
Fig. 3 is an illustration which explains some manufacturing steps in a variant of the first embodiment which shows the invention.
Fig. 4 is an illustration which explains some steps in the method of manufacturing a thin film transistor according to the second embodiment, in which the transistor is shown in cross-sectional view in each step.
Fig. 5 is a diagrammatic plan view of the masks as used in the method of manufacturing a thin film transistor according to the second embodiment

### DESCRIPTION OF THE PREFERRED EMBODIMENT(S)

Embodiments will now be described with reference to the accompanying drawings.

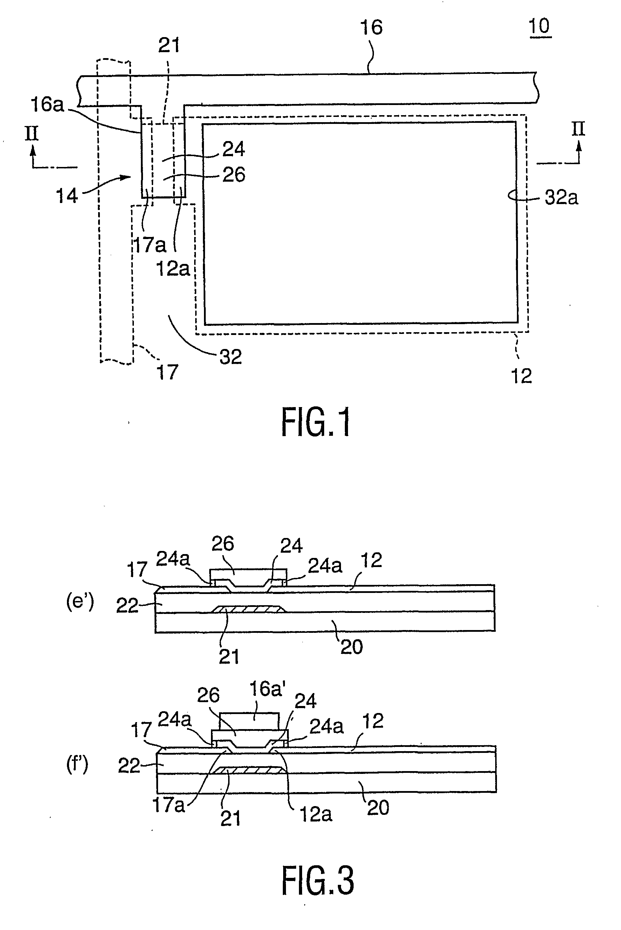

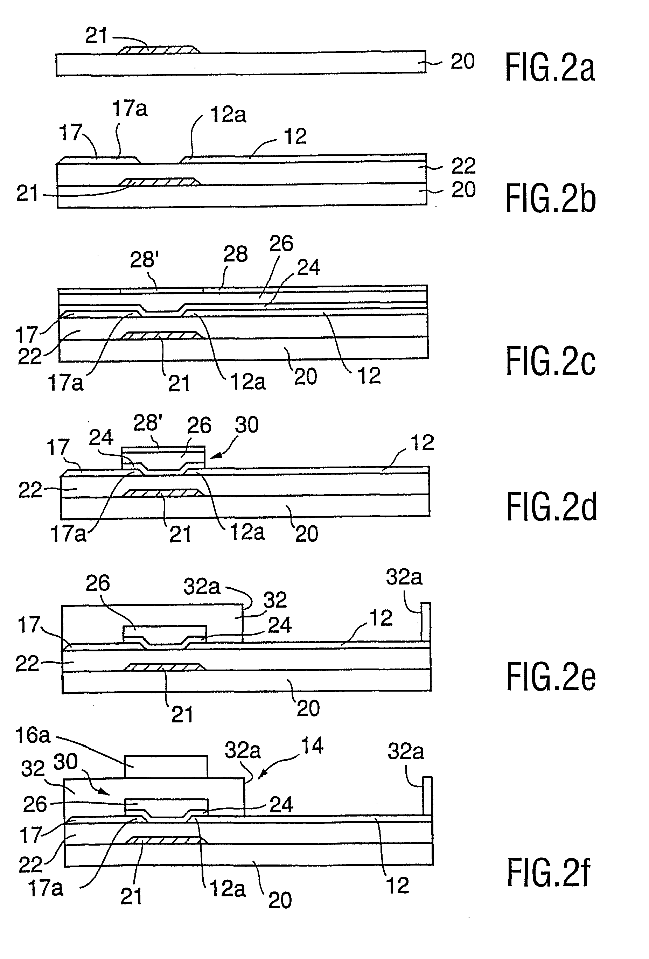

Fig. 1 is a plan view of a liquid crystal display panel manufactured by applying a first embodiment of the method of manufacturing a thin film transistor according to the invention to TFTs of the top-gate type, wherein only a part of the panel corresponding to one pixel is diagrammatically shown. Fig. 2 is an illustration showing various steps of the manufacturing method according to the first embodiment in cross-sectional views taken along line II - II of Fig. 1.

A liquid crystal display panel 10 to which the first embodiment has been applied comprises a number of pixel electrodes 12 which are formed on a transparent substrate with an insulating layer interposed therebetween and are arranged in a matrix fashion, the transparent substrate being disposed on the rear side of the panel. Each pixel electrode 12 is provided, in an adjacent relation thereto, a thin film transistor (TFT) 14 for driving this pixel electrode. The TFT 14 is connected to a gate line 16 extending in the row direction of the liquid crystal display panel 10 and to a source line 17 extending in the column direction of the panel, and is adapted to be driven by signals applied to both lines in accordance with pixel information. Although not shown in Fig. 1, the liquid crystal display panel 10 further comprises a transparent protective substrate and other elements which are disposed in an opposed relation to the above structure including the transparent substrate and those elements shown in Fig. 1 with a liquid crystal material sandwiched therebetween (that is to say, the transparent protective substrate and other elements are disposed on the front side of the panel). The panel 10 is thus arranged to display an image by applying voltages present between a transparent common electrode provided on the transparent protective substrate and the respective pixel electrodes to the liquid crystal material and illuminating the panel from the rear side by means of a back light system.

Hereinafter, the method of manufacturing the above thin film transistors 14 will be described in more detail with reference to Fig. 2. In the following description, the upper side of Fig. 2 is referred to as the front side and the lower side as the rear side as the case may be.

First, a substrate 20 made of a transparent material such as glass and quartz is prepared. Then, a film composed of a light-blocking material such as chromium is formed on the entire surface of the transparent substrate 20 with a uniform thickness, for example, by sputtering. This light-blocking material film is patterned by a known lithography utilizing a first photomask to form shield films 21 each at a position which corresponds to a respective one of the thin film transistors 14 to be fabricated (see Fig. 2 at (a)). In this manner, a number of shield films 21 each having a substantially rectangular top view are formed on the substrate 20 in a matrix fashion.

Subsequently, an insulating layer 22 composed, for example, of SiO₂ is formed on the entire surface of the substrate 20, on which the shield layers 21 have been formed, with a uniform thickness by means of a plasma CVD (Chemical Vapour Deposition) method. A layer of a transparent conductive material such as ITO is then formed on the thus formed insulating layer 22 with a uniform thickness, for example, by sputtering. This transparent conductive material layer is patterned by a known photolithography utilizing a second photomask, so that pixel electrodes 12, drain electrodes 12a each as a part of the corresponding pixel electrode 12, source lines 17 and source electrodes 17a integral with the corresponding source line 17 are formed (see Fig. 2 at (b)). Then, the structure as obtained in the step shown in Fig. 2 at (b) is doped in its upper surface with phosphorous for the subsequent steps.

Subsequently, a channel forming layer 24 composed of a semiconductor material such as amorphous silicon (a-Si) and a gate insulating layer 26 composed of an insulating material such as silicon nitride (SiNₓ) are sequentially formed on the entire surface of the above-mentioned structure, for example, in a plasma CVD method. In this case, the doped phosphorous mentioned above diffuses into the portions of the channel forming layer 24 interfacing with the pixel electrodes 12, drain electrodes 12a, source lines 17 and source electrodes 17a, whereby n+a-Si films, for example, are formed therein, which allow good ohmic contacts to be achieved between the channel forming layer 24 and the drain and source electrodes 12a and 17a. Then, a photoresist layer 28 is formed on the gate insulating layer 26. This photoresist layer 28 is exposed to a light from the side of the substrate 20 with the shield layers 21 being used as a mask. The photoresist layer 28 thus exposed to the light from the rear side is then developed, with the result that only those regions 28' which correspond to the shield layers 21, respectively, are left on the gate insulating layer 26. Subsequently, the gate insulating layer 26 and the channel forming layer 24 are selectively etched by means of a known etching method with the photoresist layers 28' being used as a mask, so that island-shaped regions 30 each including the channel forming layer 24 and the gate insulating layer 26 are formed (see Fig. 2 at (d)). The photoresist layer 28' left on each island-shaped region 30 is then removed in a known method.

Subsequently, an insulating layer 32 composed of an insulating material such as silicon nitride is formed on the entire surface of the above structure. This insulating layer 32 is then patterned in a known photolithography utilizing a third photomask, so that windows 32a each for exposing a respective one of the pixel electrodes 12 are formed in the insulating layer 32 (see Fig. 2 at (e)).

Subsequently, a metal layer composed of aluminium or the like is formed on the entire surface of the structure with a certain thickness, for example, by sputtering. This metal layer is then patterned by a known photolithography utilizing a fourth photomask, so that gate electrodes 16a each disposed above a respective one of the island-shaped regions 30 and gate lines 16 each connected in common to a row of gate electrodes 16a are formed on the insulating layer 32 (see Fig. 2 at (f)). In this manner, TFTs 14 each comprising the drain and source electrodes 12a and 17a, channel forming layer 24, gate insulating layers 26 and 31, and gate electrode 16a are obtained.

The structure as obtained in the step shown in Fig. 2 at (f) is then formed on its entire surface, for example, with a protective film and/or an orientation film, but detailed description of such steps will be omitted since they are well known.

In the manufacturing method according to the above-described first embodiment, when forming the island-shaped channel forming layers 30 each including the channel forming layer 24, the exposure to light is performed from the rear side with the shield layers 21 being used as a photomask, so that there is no need to provide another photomask which has been required in the conventional manufacturing method for the exposure from the front side, whereby the manufacturing steps are simplified. As a result of the shield layers 21 being used as a photomask, each shield layer 21 and the corresponding island-shaped channel forming layer 24 agree in shape and position to each other substantially completely when viewed in a direction perpendicular to the substrate 20, that is to say both layers are self aligned. Thus, there is practically no possibility that optically excited carriers may be induced by the light from the back light system entering the channel forming layers 24. Therefore, with the liquid crystal display panel 10 manufactured in this manufacturing method, a good picture quality which is less susceptible to the back light system can be obtained. Furthermore, the shield layers 21 will not be formed unduly large with respect to the channel forming layers 24 by virtue of the above-mentioned self-alignment, so that the entry of light from the back light system to the channel forming layers 24 can be prevented in an efficient manner and that the aforementioned reduction of numerical aperture can be avoided.

A modification of the above-described first embodiment will now be described with reference to Fig. 3. The embodiment without this modification does not fall within the scope of the claims.

This modification is to prevent side faces of the channel forming layer 24 from contacting a pattern of the gate electrode 16a by making the side faces of the channel forming layer insulative instead of covering the island-shaped region 30 in its entirety with the insulating layer 32, and has manufacturing steps which are different from those shown in Fig. 2 in the following respects.

After the step shown in Fig. 2 at (d), an insulating film 24a composed of SiO₂ is formed by the oxidization of side faces of the channel forming layer 24 by carrying out a plasma oxidation treatment in a known manner as shown in Fig. 3 at (e'). Then, the photoresist layer 28' is removed. Alternatively, the photoresist layer 28' may be removed prior to the above plasma oxidation treatment.

Subsequently, a metal layer composed of aluminium or the like is formed on the entire surface of the structure with a certain thickness, for example, by sputtering. This metal layer is then patterned by a known photolithography utilizing the fourth photomask, so that gate electrodes 16a' and gate patterns 16 are formed on the gate insulating layer 26.

According to this modification, there is no need to provide the insulating layer 32 in the first embodiment and only the single gate layer 26 is present between the channel forming layer 24 and the gate electrode 16a', which renders the manufacturing steps simpler and less expensive.

Next, a second embodiment which is not covered by the claims, in which the method of manufacturing a thin film transistor is applied to a TFT of the bottom-gate type, will be described.

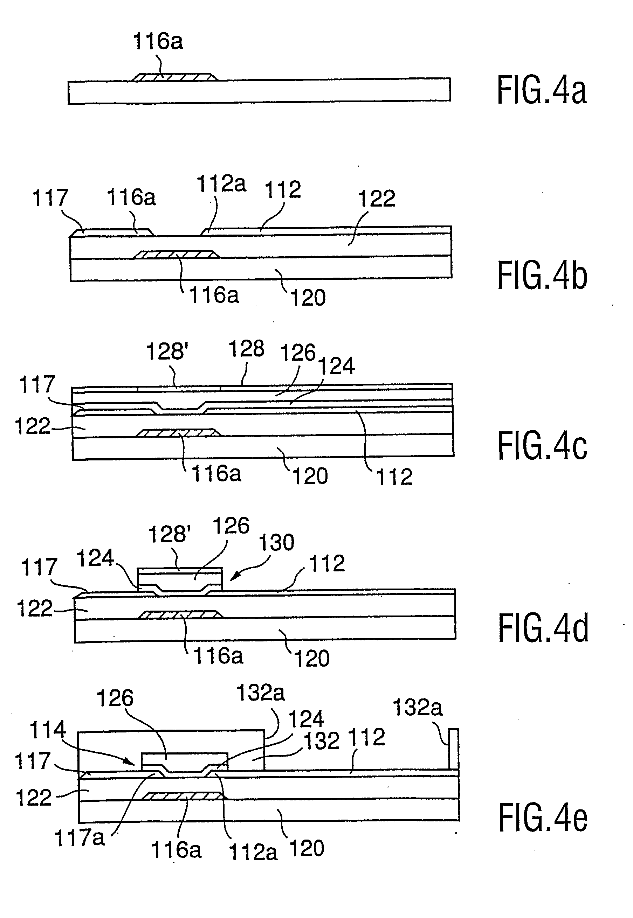

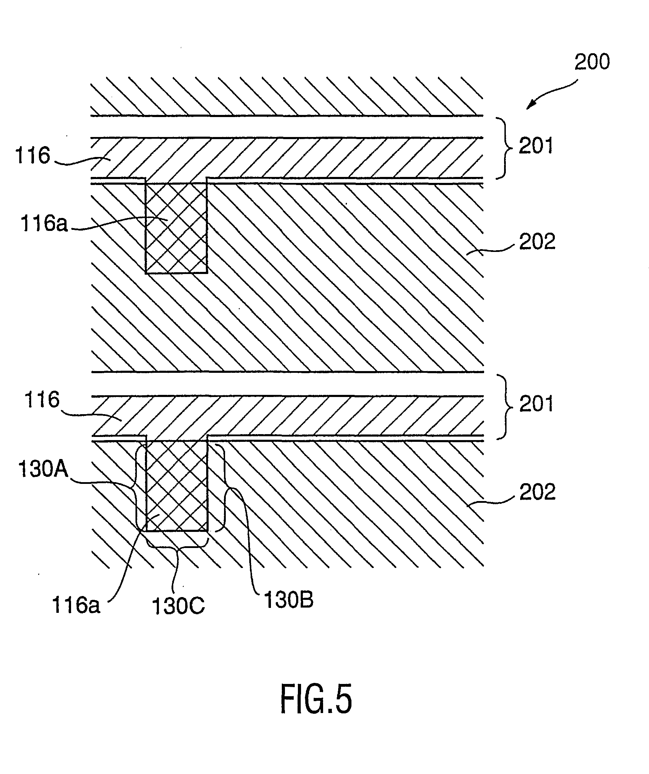

Fig. 4 is an illustration showing various steps in this second embodiment in a manner similar to Fig. 2. First, a layer composed of a light-blocking conductive material, e.g., a metal such as aluminium, is formed on the entire surface of a transparent substrate 120 made, for example, of glass or quartz with a uniform thickness by sputtering or the like. This metal layer is patterned by a known lithography utilizing a first photomask to form gate electrodes 116a and gate lines 116 (Fig. 5) each of which is integral with the gate electrodes 116a (see Fig. 4 at (a)).

Subsequently, a gate insulating layer 122 composed, for example, of SiO₂ is formed on the entire surface of the substrate 120, on which the gates electrodes 116a and the gate lines 116 have been formed, with a uniform thickness by means of a plasma CVD method or the like. A layer of a transparent conductive material such as ITO is then formed on the thus formed gate insulating layer 122 with a uniform thickness, for example, by sputtering. This transparent conductive material layer is patterned by a known photolithography utilizing a second photomask, so that pixel electrodes 112, drain electrodes 112a each as a part of the corresponding pixel electrode 112, source lines 117 and source electrodes 117a integral with the corresponding source line 117 are formed (see Fig. 4 at (b)). Then, the structure as obtained in the step shown in Fig. 4 at (b) is doped in its upper surface with phosphorous for the subsequent steps.

Subsequently, a channel forming layer 124 composed of a semiconductor material such as amorphous silicon (a-Si) and an insulating layer 126 composed of an insulating material such as silicon nitride (SiNₓ) are sequentially formed on the entire surface of the above structure, for example, in a plasma CVD method. In this case, the doped phosphorous mentioned above diffuses into the portions of the channel forming layer 124 interfacing with the pixel electrodes 112, drain electrodes 112a, source lines 117 and source electrodes 117a, whereby n+a-Si films, for example, are formed therein, which allow good ohmic contacts to be achieved between the channel forming layer 124 and the drain and source electrodes 112a and 117a. Then, a photoresist layer 128 is formed on the insulating layer 126. This photoresist layer 128 is exposed to a light from the side of the substrate 120 (i.e., from the rear side) with the gate electrodes 116a and gate lines 116 being used as one mask. Further, the photoresist layer 128 is exposed to a light from the upper side in the drawing (i.e., from the front side of the panel) using a third photomask (the other photomask) of a simple configuration which has predetermined light-blocking stripes extending in a direction perpendicular to the length of the gate electrodes 116a (that is to say, in the horizontal direction in Fig. 4).

Fig. 5 schematically illustrates the above-mentioned one and the other masks in a plan view, and shows that the one mask with the gate electrodes 116a and gate lines 116 and the other mask 200 have overlapping areas (cross-hatched areas) which are those regions where the channel forming layers should be formed. More specifically, the other mask 200 should have such a pattern that at least those regions which correspond to the gate electrodes 116a, i.e., the channel forming layers, are not exposed to the light from the top side. In the present example, the mask 200 has a pattern which causes all the regions of the gate lines 116 to be exposed to the light from the top side. This pattern can be formed by providing light-transmissive linear stripes 201 which extend along the gate lines 116 to encompass them and light-blocking linear stripes 202 arranged alternately with the stripes 201, and is thus very simple. As will be appreciated from Fig. 5, the mask 200 should only be positioned in one direction (i.e., in the vertical direction in Fig. 5) and thus contributes to the simplification of the manufacturing steps.

The photoresist layer 128 thus exposed to light is then developed, with the result that only those regions 128' which correspond to the gate electrodes 116a, respectively, are left on the insulating layer 126. Subsequently, the insulating layer 126 and the channel forming layer 124 are selectively etched by means of a known etching method with the photoresist layers 128' being used as a mask, so that island-shaped regions 130 each including the channel forming layer 124 and the insulating layer 126 are formed (see Fig. 4 at (d)). The photoresist layer 128' left on each island-shaped region 130 is then removed in a known method.

Subsequently, a protective layer 132 composed of an insulating material such as silicon nitride is formed on the entire surface of the above structure. This protective layer 132 is then patterned in a known photolithography utilizing a fourth photomask, so that windows 132a each for exposing a respective one of the pixel electrodes 112 are formed in the protective layer 132 (see Fig. 4 at (e)). Subsequently, terminal portions of the gate lines are exposed in a known method. In this manner, TFTs 114 each comprising the drain and source electrodes 112a and 117a, channel forming layer 124, gate insulating layer 122, and gate electrode 116a are obtained.

The structure as obtained in the step shown in Fig. 4 at (e) is then formed on its entire surface, for example, with an orientation film, but detailed description of such steps will be omitted since they are well known.

In the manufacturing method according to the above-described second embodiment, when forming the island-shaped channel forming layers 130 each including the channel forming layer 124, the exposure to light is performed from the rear side with the gate electrodes 116a being used as a photomask, so that when viewed in a direction perpendicular to the substrate 120 each gate electrode 116a and the corresponding channel forming layer 124 agree in shape and position to each other substantially completely, that is to say both layers are self aligned, at least with respect to a pair of opposite sides thereof (the sides 130A and 130B shown in Fig. 5; in the present example, the side 130C is also self-aligned). Thus, the possibility that optically excited carriers may be induced by the light from the back light system entering the channel forming layers 124 is quite low. Therefore, with the liquid crystal display panel manufactured in this manufacturing method, a good picture quality which is less susceptible to the back light system can be obtained. Furthermore, by virtue of the above-mentioned self-alignment, the entry of light from the back light system to the channel forming layers can be prevented in an efficient manner and at the same time the aforementioned reduction of numerical aperture can be avoided.

In the manufacturing steps of the second embodiment shown in Fig. 4 from (c) to (e), the formation of the insulating layer 126 may be omitted and instead only the protective layer 132 may be provided.

In the above-described second embodiment, the island-shaped region 130 is formed utilizing the one mask (the gate electrodes and so on) on the rear side and the other mask on the front side. Alternatively, the channel forming layer is first patterned into shapes corresponding to the gate electrodes and so on (in plan view) in the step of Fig. 4 (c) solely with the one mask, and then the channel forming layer is finally patterned into the island shapes simultaneously with the formation of the windows 132a in the protective layer 132 in the step of Fig. 4 (e). In this case, upon the patterning of the channel forming layer into the island shapes the side faces thereof will be exposed, so that it will be desirable to subject these exposed side faces to an insulating treatment such as an oxidation treatment and a nitriding treatment in a manner described above with reference to Fig. 3. As a matter of course, the patterning into island shapes described above is not essential since the channel forming layers can achieve their fundamental functions even if they are not formed into island shapes. Nevertheless, it will be desirable to form the channel forming layer into island shapes when the performance of the TFT in terms of the resistance to leakage currents or the like is taken into consideration.

Although the shield layers and the gate electrodes are formed directly on the substrate in the above-described respective embodiments, it goes without saying that these elements may alternatively be formed on an under-coat layer provided on the substrate. Likewise, the invention does not exclude the provision of additional elements in other layers and parts. Also, any modification is possible to the embodiments of the invention as required without departing from the scope of the invention described in the claims.

## Claims

1. A method of manufacturing a thin film transistor comprising
a substrate (20);
a source (12a) and a drain electrode (17a) that are mutually separated by a channel (24), and
a gate electrode (16a) that is isolated from the channel through a gate insulating layer (26), wherein the gate electrode (16a) is formed on the island-shaped channel (24) with the gate insulating layer (260 being interposed therebetween, the channel being formed comprising the steps of applying a channel forming layer (24)and photolithographical patterning of the channel forming layer (24) with a mask, wherein the substrate (20) is transparent and is provided with the mask for patterning the channel forming layer (24), the mask being a shield layer (21) to prevent light from entering the channel, **characterized by** providing the source (12a) and drain electrodes (17a) on the substrate, onto which the channel forming layer is applied; oxidizing side faces of said channel (24) comprising amorphous silicon, and forming said gate electrode (16a) on said channel (24) having the oxidized side faces with the gate insulating layer(26) being interposed therebetween.

2. A method as claimed in Claim 1, **characterized in that** the photolithographical patterning comprises the steps of:
- providing a photoresist layer (28) on the gate insulating layer (26);
- patterning the photoresist layer (28) based on exposing light from the side of said transparent substrate (20) with said shield layer (21) being used as a mask; and
- selectively etching a lamination of said gate insulating layer (26) and said channel forming layer (24) with the patterned photoresist layer being used as a mask, therewith forming the island-shaped channel (30).

3. A method according to Claim 1 or 2, **characterized in that** the oxidation of side faces of the channel forming layer (24) is carried out a plasma oxidation treatment.

## Patentansprüche

1. Verfahren zum Herstellen eines Dünnfilmtransistors, umfassend
ein Substrat (20);
eine Quell- (12a) und eine Drain-Elektrode (17a), die gegenseitig durch einen Kanal (24) getrennt sind, und
eine Gate-Elektrode (16a), die von dem Kanal durch eine Gate-isolierende Schicht (26) isoliert ist, wobei die Gate-Elektrode (16a) auf dem inselförmigen Kanal (24) mit der dazwischen eingefügten Gate-isolierenden Schicht (26) gebildet ist, wobei der Kanal ausgebildet wird, umfassend die Schritte des Aufbringens einer Kanal bildenden Schicht (24) und photolithographischem Mustergeben der Kanal bildenden Schicht (24) mit einer Maske, wobei das Substrat (20) transparent ist und mit der Maske zur Mustergebung der Kanal bildenden Schicht (24) bereitgestellt ist, wobei die Maske eine Abdeckschicht (21) ist, um Licht vor dem Eindringen in den Kanals zu hindern, **gekennzeichnet durch** Bereitstellen der Quell- (12a) und Drain Elektroden (17a) auf dem Substrat, auf dem die Kanal bildende Schicht aufgebracht wird; Oxidieren von Stirnseiten des Kanals (24), der amorphes Silizium umfasst, und Ausbilden der Gate-Elektrode (16a) auf dem Kanal (24) mit den oxidierten Stirnseiten mit der dazwischen eingefügten Gate-isolierenden Schicht (26).

2. Verfahren wie in Anspruch 1 beansprucht, **dadurch gekennzeichnet, dass** das photolithographische Mustergeben die Schritte umfasst:
- Bereitstellen einer Photoresistschicht (28) auf der Gate-isolierenden Schicht (26);
- Mustergeben der Photoresistschicht (28) basierend auf dem Exponieren von Licht von der Seite des transparenten Substrats (20), wobei die Abdeckschicht (21) als eine Maske verwendet wird; und
- selektives Ätzen einer Laminierung der Gate-isolierenden Schicht (26) und der Kanal bildenden Schicht (24) mit der als Maske verwendeten gemusterten Photoresistschicht, dadurch Ausbilden des inselförmigen Kanals (30).

3. Verfahren nach Anspruch 1 oder 2, **dadurch gekennzeichnet, dass** die Oxidation der Stirnseiten der Kanal bildenden Schicht (24) als eine Plasmaoxidationsbehandlung durchgeführt wird.

## Revendications

1. Procédé de fabrication d'un transistor à couches minces comprenant
un substrat (20) ;
une source (12a) et une électrode de drain (17a) qui sont séparées l'une de l'autre par un canal (24), et
une électrode de grille (16a) qui est isolée du canal par l'intermédiaire d'une couche d'isolation de grille (26), où l'électrode de grille (16a) est formée sur le canal en forme d'îlot (24), la couche d'isolation de grille (260) étant interposée entre eux, la formation du canal comprenant les étapes qui consistent à appliquer une couche de formation de canal (24) et à former des motifs par photolithographie sur la couche de formation de canal (24) avec un masque, où le substrat (20) est transparent et est muni du masque pour former des motifs sur la couche de formation de canal (24), le masque étant une couche de blindage (21) pour empêcher la lumière d'entrer dans le canal, **caractérisé par** le fait de fournir la source (12a) et les électrodes de drain (17a) sur le substrat, sur lequel la couche de formation de canal est appliquée ; d'oxyder des faces latérales dudit canal (24) comprenant du silicium amorphe et de former ladite électrode de grille (16a) sur ledit canal (24) ayant les faces latérales oxydées, la couche d'isolation de grille (26) étant interposée entre elles.

2. Procédé tel que revendiqué dans la revendication 1, **caractérisé en ce que** la formation de motifs par photolithographie comprend les étapes qui consistant :
- à fournir une couche photorésistante (28) sur la couche d'isolation de grille (28) ;
- à former des motifs sur la couche photorésistante (28) sur la base d'une lumière d'exposition à partir du côté dudit substrat transparent (20), ladite couche de blindage (21) étant utilisée en tant que masque ; et
- à graver sélectivement une stratification de ladite couche d'isolation de grille (26) et de ladite couche de formation de canal (24), la couche photorésistante à motifs étant utilisée en tant que masque, formant avec celle-ci le canal en forme d'îlot (30).

3. Procédé selon la revendication 1 ou 2, **caractérisé en ce que** l'oxydation de faces latérales de la couche de formation de canal (24) est réalisée par un traitement d'oxydation au plasma.
